# EUROPÄISCHE PATENTANMELDUNG

(11) **EP 3 157 113 A1**
(43) Veröffentlichungstag der Anmeldung: **19.04.2017**
(21) Anmeldenummer: 16192305.7
(22) Anmeldetag: 05.10.2016
(51) Int. Cl.: H02H 3/17, H02H 1/00

(54) **ISOLATIONSFEHLER-SCHUTZEINRICHTUNG MIT ABSCHALTFUNKTION FÜR UNGEERDETE STROMVERSORGUNGSSYSTEME**

(30) Priorität: 16.10.2015 DE 102015117678
(71) Anmelder: Bender GmbH & Co. KG, 35305 Grünberg (DE)
(72) Erfinder: HOFHEINZ, Wolfgang, 35305 Grünberg (DE); Dipl.-Ing. SELLNER, Harald, 35305 Grünberg (DE)
(74) Vertreter: advotec.

(57) **Zusammenfassung**

Die Erfindung betrifft eine Isolationsfehler-Schutzeinrichtung (2) für ein ungeerdetes Stromversorgungssystem (4), mit einem normgemäßen Isolationsüberwachungsgerät (12) zur Überwachung eines Isolationswiderstands des ungeerdeten Stromversorgungssystems und mit einer Abschaltvorrichtung (14) zur Trennung des Stromversorgungssystems, wobei die Abschaltvorrichtung mittels einer Signalleitung (16) mit der Isolationsüberwachungseinrichtung unmittelbar verbunden ist und im Fall eines von dem Isolationsüberwachungsgerät erkannten ersten Isolationsfehlers das Isolationsüberwachungsgerät ein Abschaltsignal über die Signalleitung an die Abschaltvorrichtung ausgibt.

## Beschreibung

Die Erfindung betrifft eine Isolationsfehler-Schutzeinrichtung für ein ungeerdetes Stromversorgungssystem, mit einem normgemäßen Isolationsüberwachungsgerät zur Überwachung eines Isolationswiderstands des ungeerdeten Stromversorgungssystems.

Bekannt sind nach der internationalen Norm IEC 61557-8 spezifizierte Isolationsüberwachungsgeräte, die zur Überwachung des Isolationswiderstands in ungeerdeten Stromversorgungssystemen (frz. Isolé Terre - IT-Systeme) eingesetzt werden. Dabei wird der besondere Vorteil der IT-Systeme genutzt, dass keine Abschaltung (Trennung) des Stromversorgungssystems vorgenommen wird, somit eine kontinuierliche Stromversorgung der von dem IT-Stromversorgungsystem gespeisten Verbraucher auch dann gewährleistet ist, wenn ein, beispielsweise durch einen Erdschluss oder einen Körperschluss verursachter, erster Isolationsfehler auftritt, da die aktiven Teile des IT-Stromversorgungssystems von dem Erdpotenzial - gegenüber "Erde" - getrennt sind und sich in diesem ersten Fehlerfall kein geschlossener Stromkreis ausbilden kann. Es fließt lediglich ein meist sehr geringer kapazitiver Fehlerstrom, der durch die Netzableitkapazitäten der Leitungsanlage des IT-Systems bestimmt wird.

Neben den bekannten Verwendungsgebieten, in denen ein Isolationsüberwachungsgerät normgemäß ausschließlich als Überwachungseinrichtung eingesetzt wird, beispielsweise in IT-Systemen in medizinisch genutzten Bereichen, gelangen zunehmend Anwendungsbereiche in den Vordergrund, in denen auch eine Abschaltung von ungeerdeten Stromversorgungssystemen, insbesondere von ungeerdeten Gleichstromsystemen, gefordert wird. Beispielhaft ist hier die Anwendung von Ladegeräten in der Elektromobilität, bei Generatoren in der Landwirtschaft oder im Rohrleitungsbau oder auch bei Tauchgeräten genannt. Hier ist also neben der Überwachungssaufgabe auch eine elektrische Schutzfunktion in Form einer Trenneigenschaft/Abschaltfunktion erforderlich.

Eine derartige schaltende Funktion führen in bekannter Weise Fehlerstrom-Schutzeinrichtungen (RCD) in geerdeten Stromversorgungssystemen aus, die allerdings aufgrund ihres Wirkprinzips der Differenzstrom-Messung in ungeerdeten Wechselstrom- bzw. Gleichstrom-Systemen bei Auftreten eines ersten Fehlers unwirksam bleiben. Im Gegensatz zu den in geerdeten Stromversorgungssystemen einsetzbaren Schutzeinrichtungen - wie Fehlerstrom-Schutzeinrichtungen (RCD) oder Überstrom-Schutzeinrichtungen - sind in ungeerdeten Stromversorgungssystemen keine in ihrer Funktionalität vergleichbaren Schutzeinrichtungen verfügbar oder treten nur bei Auftreten eines zweiten Isolationsfehlers an einem anderen Außenleiter in Erscheinung.

Der vorliegenden Erfindung liegt somit die Aufgabe zu Grunde, eine elektrische Schutzeinrichtung für ein ungeerdetes Stromversorgungssystem zu schaffen, die neben einer Isolationsüberwachung eine weitergehende Schutzfunktion bei Auftreten eines ersten Isolationsfehlers erfüllt.

Diese Aufgabe wird gelöst durch eine Isolationsfehler-Schutzeinrichtung für ein ungeerdetes Stromversorgungssystem, mit einem normgemäßen Isolationsüberwachungsgerät zur Überwachung eines Isolationswiderstands des ungeerdeten Stromversorgungssystems und mit einer Abschaltvorrichtung zur Trennung des Stromversorgungssystems, wobei die Abschaltvorrichtung mittels einer Signalleitung mit der Isolationsüberwachungseinrichtung unmittelbar verbunden ist und im Fall eines von dem Isolationsüberwachungsgerät erkannten ersten Isolationsfehlers das Isolationsüberwachungsgerät ein Abschaltsignal über die Signalleitung an die Abschaltvorrichtung ausgibt.

Durch die Kombination eines Isolationsüberwachungsgerätes mit einer Abschaltvorrichtung vereint die erfindungsgemäße Isolationsfehler-Schutzeinrichtung die Überwachungsfunktion einer normativ vorgeschriebenen Isolationsüberwachung mit der Schutzfunktion einer Fehlerstromschutzeinrichtung. Stellt das Isolationsüberwachungsgerät entsprechend seiner Bestimmung eine Unterschreitung eines einstellbaren und an das zu überwachende IT-Stromversorgungssystem angepassten Isolationswiderstands-Grenzwertes fest, was dem Auftreten eines ersten Isolationsfehlers entspricht, so gibt das Isolationsüberwachungsgerät ein Abschaltsignal über eine Signalleitung unmittelbar an die Abschaltvorrichtung aus und es erfolgt mittels der Abschaltvorrichtung eine Trennung der Stromversorgung für an das ungeerdete Stromversorgungssystem angeschlossene Verbraucher. Die erfindungsgemäße Isolationsfehler-Schutzeinrichtung umfasst damit neben der Funktion der Isolationswiderstandsüberwachung auch eine abschaltende Funktion, wie sie von Fehlerstrom-Schutzeinrichtungen bekannt ist.

Die Information über die Erkennung eines ersten Isolationsfehlers durch das Isolationsüberwachungsgerät wird in vorteilhafter Weise unmittelbar in der Abschalteinrichtung zur Trennung des Stromversorgungssystems genutzt. Insbesondere stellt die aufgrund der vorgeschriebenen Messeigenschaften sichergestellte Erkennung von symmetrischen und unsymmetrischen Isolationsfehlern durch das Isolationsüberwachungsgerät einen bedeutenden Sicherheitsvorsprung dar.

Die erfindungsgemäße Isolationsfehler-Schutzeinrichtung als sicherheitsbezogenes System in Form eines Isolationsüberwachungsgerätes mit Abschalteinrichtung ermöglicht darüber hinaus weitere Anwendungen für ungeerdete Systeme, die bislang wegen der für ungeerdete Systeme nicht verfügbaren Schutzeinrichtungen nur geerdeten Systemen vorbehalten sind.

Durch die erfindungsgemäße Isolationsfehler-Schutzeinrichtung können auch neuen Erkenntnissen und künftigen Anwendungen Rechnung getragen werden. So kann den Tatsachen begegnet werden, dass Schutzeinrichtungen für Gleichspannungssysteme auf dem Markt nicht verfügbar sind und dass eine nachteilige Beeinflussung des Abschaltverhaltens von Fehlerstrom-Schutzeinrichtungen (RCD) durch Gleichstromfehler in Untersuchungen deutlich wurde. Zudem wurden die Vorteile eines IT-Systems mit Abschaltung erkannt, es liegen zunehmend mehr praktische Erfahrungen zur Entstehung von symmetrischen Isolationsfehlern vor und eine Sensorik für 6 mA Gleichströme in den bekannten Netzformen wurde in verschiedene Normen eingebracht, die es zu berücksichtigen gilt.

Die erfindungsgemäße Isolationsfehler-Schutzeinrichtung ist gleichermaßen für Wechselstrom- und Gleichstrom-Versorgungssysteme geeignet. Insbesondere kann die für die Erkennung von Gleich-Fehlerströmen oder für die Erkennung von Wechsel-Fehlerströmen mit Gleichanteil in üblichen Fehlerstrom-Schutzeinrichtungen (RCD) verbaute aufwändige Messtechnik auf Basis des Differenzstrom-Messprinzips entfallen.

In weiterer Ausgestaltung weist die Abschaltvorrichtung einen Kontaktsatz zur Trennung von Leitern des Stromversorgungssystems auf.

Hinsichtlich der Funktionalität und der Trenneigenschaften genügt die Isolationsfehler-Schutzeinrichtung damit den gleichen Sicherheitsstandards wie eine Fehlerstrom-Schutzeinrichtung.

Vorteilhafterweise bilden das normgemäße Isolationsüberwachungsgerät und die Abschaltvorrichtung eine gemeinsame bauliche Einheit aus.

Die Isolationsfehler-Schutzeinrichtung stellt somit eine bauliche Einheit in kompakter Form dar, die deren praktische Verwendung, beispielsweise in einer Installation, einfach gestaltet.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: die Anwendung einer erfindungsgemäßen Isolationsfehler-Schutzeinrichtung in einem ungeerdeten Wechselstrom-Versorgungssystem und
- **Fig. 2:**: die Anwendung einer erfindungsgemäßen Isolationsfehler-Schutzeinrichtung in einem ungeerdeten Gleichstrom-Versorgungssystem.

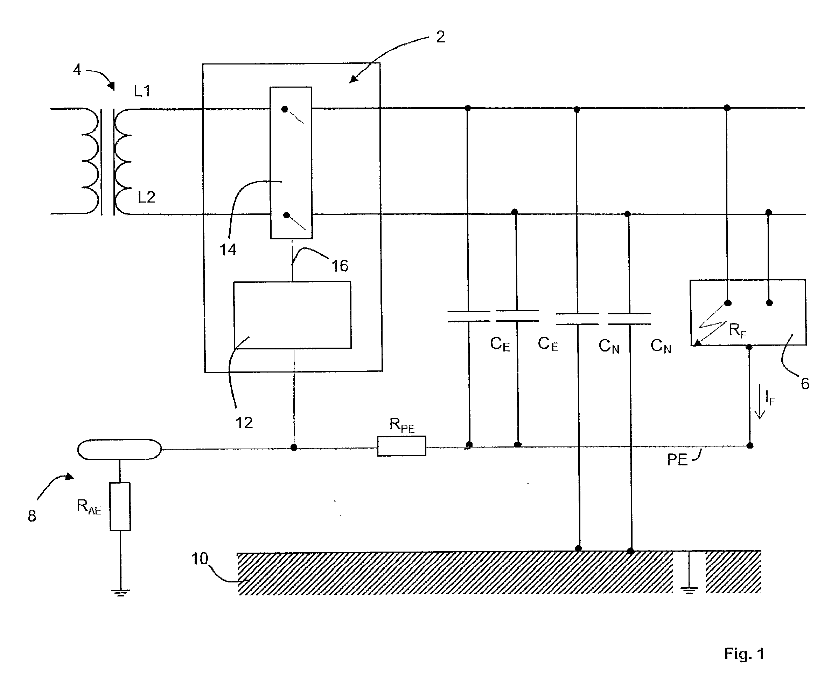

In **Fig. 1** ist schematisch die Installation einer erfindungsgemäßen Isolationsfehler-Schutzeinrichtung 2 in einem ungeerdeten Wechselstrom-Versorgungssystem 4 mit zwei Leitern L1 und L2 dargestellt. An einem Betriebsmittel 6 ist beispielhaft zwischen dem Leiter L1 und dem Körper des Betriebsmittels 6 ein erster Isolationsfehler R_{F} aufgetreten, der einen Fehlerstrom I_{F} zur Folge hat. Der Fehlerstromkreis schließt sich in Teilen über einen Schutzleiter PE mit einem Schutzleiterwiderstand R_{PE} und einen Widerstand R_{AE} eines mit dem Erdreich 10 verbundenen Erders 8 sowie über Kabel- und Leitungskapazitäten C_{E} und natürliche Ableitkapazitäten C_{N}.

Die Isolationsfehler-Schutzeinrichtung 2 umfasst ein normgemäßes Isolationsüberwachungsgerät 12 mit funktionaler Sicherheit, welches die Anforderungen erfüllt, die beispielsweise in der internationalen Norm IEC 61557-8 festgeschrieben sind. Dabei überlagert das zwischen den Leitern L1, L2 und dem Schutzleiter PE angeschlossene Isolationsüberwachungsgerät 12 dem Stromversorgungssystem 4 aktiv eine Messspannung, wobei sich ein dem Isolationswiderstand entsprechender Messstrom einstellt, der wiederum einen in dem Isolationsüberwachungsgerät 12 messbaren Spannungsabfall zur Folge hat. Im Fall des hier dargestellten Isolationsfehlers R_{F} sinkt der Isolationswiderstand unterhalb eines für das zu überwachende Stromversorgungssystem 4 einstellbaren, charakteristischen Wert. Dies wird von dem Isolationsüberwachungsgerät 12 als erster Isolationsfehler erkannt und daraufhin eine erfindungsgemäß vorgesehene Abschaltvorrichtung 14, die mittels einer Signalleitung (16) mit der Isolationsüberwachungseinrichtung (12) unmittelbar verbunden ist, zur Trennung des Stromversorgungssystems 4 aktiviert. Die Abschaltvorrichtung 14 kann dabei als integraler Bestandteil der Isolationsfehler-Schutzeinrichtung 2 in einem gemeinsamen Gehäuse mit dem Isolationsüberwachungsgerät 12 angeordnet sein.

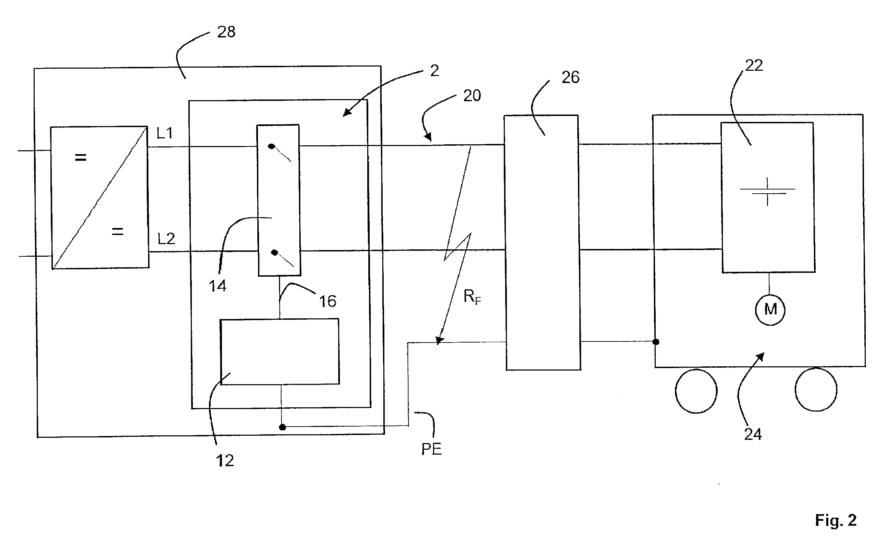

**Fig. 2** zeigt die Anwendung einer erfindungsgemäßen Isolationsfehler-Schutzeinrichtung 2 am Beispiel einer Aufladung eines elektrischen Energiespeichers 22 eines Elektrofahrzeugs 24 mit einer Ladeeinrichtung 26 ("Electrical Vehicle Supply Equipment" - EVSE) über ein ungeerdetes Gleichstrom-Versorgungssystem 20.

Das Absinken des Isolationswiderstands durch den zwischen dem Leiter L1 und dem Schutzleiter PE aufgetretenen ersten Isolationsfehler R_{F} wird von dem Isolationsüberwachungsgerät 12 der Isolationsfehler-Schutzeinrichtung 2 detektiert und daraufhin über die Signalleitung 16 ein Abschaltsignal an die Abschalteinrichtung 14 ausgegeben. Diese trennt die Leiter L1, L2 des Stromversorgungssystems 20. Die erfindungsgemäße Isolationsfehler-Schutzeinrichtung 2 kann dabei Bestandteil einer DC-Ladestation 28 sein.

Gerade auf dem Gebiet der Elektromobilität ist die Verwendung der erfindungsgemäßen Isolationsfehler-Schutzeinrichtung 2 mit bedeutsamen Vorteilen verbunden. So kann die Anwendung eines abschaltbaren DC-IT-Systems 20 eine Reduzierung der Leiterquerschnitts des Schutzleiters PE in der Ladestation 28 ermöglichen. Besonders bei sehr hohen Ladespannungen und Ladeströmen ist die Auslegung des Schutzleiterquerschnittes aus Volumen und Gewichtsgründen von Bedeutung.

Bei IT-Systemen 4, 20, die aufgrund der installierten erfindungsgemäßen Isolationsfehler-Schutzeinrichtung 2 abschaltbar sind, kann der Fehlerstrom I_{F} zur Errechnung des Querschnitts des Schutzleiters PE herangezogen werden.

Als maximale Abschaltzeit des IT-Systems 4, 20 kann die Abschaltzeit der Norm IEC 61557-8 von 100 Sekunden zugrunde gelegt werden. Mit einem zweiten Fehler an einem anderen Leiter innerhalb dieser Abschaltzeit ist nicht zu rechnen, da das gleichzeitige Auftreten von zwei unabhängigen und nicht aufeinander bezogenen Fehlern normalerweise unberücksichtigt bleiben kann, weil die Wahrscheinlichkeit eines solchen Vorfalls so gering ist, dass das Risiko im Allgemeinen toleriert werden kann.

## Patentansprüche

1. Isolationsfehler-Schutzeinrichtung (2) für ein ungeerdetes Stromversorgungssystem (4, 20), mit einem normgemäßen Isolationsüberwachungsgerät (12) zur Überwachung eines Isolationswiderstands des ungeerdeten Stromversorgungssystems (4, 20),
**gekennzeichnet durch**
eine Abschaltvorrichtung (14) zur Trennung des Stromversorgungssystems (4, 20), wobei die Abschaltvorrichtung (14) mittels einer Signalleitung (16) mit der Isolationsüberwachungseinrichtung (12) unmittelbar verbunden ist und im Fall eines von dem Isolationsüberwachungsgerät (12) erkannten ersten Isolationsfehlers das Isolationsüberwachungsgerät (12) ein Abschaltsignal über die Signalleitung (16) an die Abschaltvorrichtung (14) ausgibt.

2. Isolationsfehler-Schutzeinrichtung nach Anspruch 1,
**dadurch gekennzeichnet,**
**dass** die Abschaltvorrichtung (14) einen Kontaktsatz zur Trennung von Leitern des Stromversorgungssystems (4, 20) aufweist.

3. Isolationsfehler-Schutzeinrichtung nach Anspruch 1 oder 2,
**dadurch gekennzeichnet,**
**dass** das normgemäße Isolationsüberwachungsgerät (12) und die Abschaltvorrichtung (14) eine gemeinsame bauliche Einheit ausbilden.
